# EUROPÄISCHE PATENTSCHRIFT

(11) **EP 0 505 681 B1**
(45) Veröffentlichungstag und Bekanntmachung des Hinweises auf die Patenterteilung: **06.03.1996**
(21) Anmeldenummer: 92101215.9
(22) Anmeldetag: 25.01.1992
(51) Int. Cl.: F16M 1/00, H05K 7/18

(54) **Vorrichtung zum Anbringen einer Platte an einer Gehäuseöffnung**
Device for mounting a panel in a case opening
Dispositif de montage d'une plaque dans une ouverture de carter

(30) Priorität: 23.03.1991 DE 4109695
(43) Veröffentlichungstag der Anmeldung: 30.09.1992
(73) Patentinhaber: Rittal-Werk Rudolf Loh GmbH & Co. KG, D-35745 Herborn (DE)
(72) Erfinder: Reuter, Wolfgang, W-5909 Burbach-Würgendorf (DE)
(74) Vertreter: Vogel, Georg

(56) Entgegenhaltungen:
- WO-A-81/00443
- GB-A- 1 489 278
- GB-A- 2 029 922
- GB-A- 2 083 342
- US-A- 3 182 769

## Beschreibung

Die Erfindung betrifft eine Vorrichtung zum Anbringen einer Platte an einer Gehäuseöffnung, die an mindestens zwei einander gegenüberliegenden Seiten mit Rahmenschenkeln abgeschlossen ist, bei der die Rahmenschenkel auf den einander zugekehrten Seiten mit einer Aufnahmenut versehen sind, die aus einem Nutgrund und zwei Nutwänden gebildet ist, bei der die Nutwände mit zur Aufnahmenut hin senkrecht stehenden Haltestegen vorstehen, bei der in die Aufnahmenuten der Rahmenschenkel in Schrägstellung Befestigungsteile einführbar sind, bei der die auf der Außenseite der Gehäuseöffnung liegende äußere Nutwand länger ist als die auf der Innenseite der Gehäuseöffnung liegende innere Nutwand, bei der die Befestigungsteile mit einem Rastkopf versehen sind, und bei der der Rastkopf der inneren Nutwand zugekehrt einen Rastfinger und der äußeren Nutwand zugekehrt einen Rastabsatz aufweist.

Eine Vorrichtung dieser Art ist in der GB-A-1 489 278 als bekannt ausgewiesen. Bei dieser bekannten Vorrichtung besitzt der Rastkopf zwei den Haltestegen zugekehrte Vertiefungen, in die Haltestege im eingerasteten Zustand eingreifen, so daß das Befestigungsteil an seinem Rastkopf gehalten ist. Die die Gehäuseöffnung verschließende Platte wird zwischen zwei Schenkeln einer jeweiligen U-förmigen Aufnahme der Befestigungsteile gehalten.

Eine ähnliche Vorrichtung ist in der DE-A-30 28 763 angegeben. Bei dieser bekannten Vorrichtung sind die Rahmenschenkel zweiteilig und bilden erst nach dem Zusammensetzen die Aufnahmenuten. Die Platte muß vor dem Zusammenbau der Rahmenschenkel auf die inneren Nutwände aufgelegt werden. Die äußeren Nutwände sind Teil von zweiten Profilabschnitten, die mit Grund-Profilabschnitten der Rahmenschenkel verbindbar sind. Der Zusammenbau eines Rahmengestelles erfordert daher eine ganz bestimmte Reihenfolge der Montageschritte.

Bei Modulgehäusen, Baugruppenträgern, Schaltschränken und Schaltpulten ist es auch bekannt, die Rahmenschenkel mit Befestigungsflanschen zu versehen und die Platte an mehreren Stellen mit den Befestigungsflanschen zu verschrauben. Dies ist aber mit erheblichem Teile- und Montageaufwand verbunden.

Es ist Aufgabe der Erfindung, eine Vorrichtung der eingangs erwähnten Art zu schaffen, mit der eine Platte auf einfache Weise in eine zwischen zwei einstückigen Rahmenschenkeln gebildete Öffnung eingesetzt und fest mit diesen verbunden werden kann, ohne daß die Rahmenschenkel an bestimmten Stellen mit Befestigungsbohrungen oder Gewindeaufnahmen versehen werden müssen.

Diese Aufgabe wird bei einer gattungsgemäßen Vorrichtung nach der Erfindung dadurch gelöst, daß die Außenseite der Nutwand als Auflage für die Platte dient, daß sich der Rastkopf des in die Aufnahmenut eingeführten Befestigungsteils mit einer Stützkante an dem Nutgrund abstützt, daß beim Verschwenken des Befestigungsteils in Richtung zur Platte der Rastfinger zwischen einen Raststeg und den Haltesteg der inneren Nutwand eingerastet ist und der Rastabsatz sich an den Haltesteg der äußeren Nutwand anlegt und daß die Platte an jedem Rahmenschenkel mittels Schraubverbindungen mit mindestens einem in die Aufnahmenut eingerasteten Befestigungsteil verbunden ist.

Diese Befestigungsteile können in die Aufnahmenuten der einstückigen Rahmenschenkel eingerastet und dann in den Aufnahmenuten an beliebige Stellen verschoben werden. Dabei bleiben die Befestigungsteile in der eingerasteten Stellung, die zum Anbringen der Platte dient, gehalten, so daß die Befestigungsschrauben nur noch durch Bohrungen der Platte eingeführt und mit den Befestigungsteilen verschraubt werden müssen.

Die Platte ist so ausgelegt, daß die Platte zumindest einen Teil der Breite oder Höhe der Gehäuseöffnung abdeckt. Selbstverständlich kann die Platte auch die gesamte Gehäuseöffnung abdecken. Sind an allen Seiten der Gehäuseöffnung Rahmenschenkel angebracht, dann kann die Platte an allen vier Seiten mit den zugekehrten Rahmenschenkeln verbunden werden.

Das Befestigungsteil wird in einer Schrägstellung in die Aufnahmenut eingeführt, die etwa senkrecht zu der durch die beiden Haltestege begrenzten Einführungsöffnung gerichtet ist. Dann wird das Befestigungsteil seitlich so verschoben, daß der Rastfinger hinter den Haltesteg der inneren Nutwand gelangt.

Wird das Befestigungsteil zur äußeren Nutwand hin verschwenkt, dann rastet der Rastfinger hinter den Raststeg der inneren Nutwand, wobei deren Haltesteg die Schwenkbewegung begrenzt. Gleichzeitig rastet der Haltesteg der äußeren Nutwand hinter den Rastabsatz des Rastkopfes, so daß das Befestigungsteil mit seinem aus dem Aufnahmeteil ragenden Ende parallel zu den Nutwänden und damit auch zu der auf der äußeren Nutwand aufgelegten Platte verläuft.

Um eine eindeutige Rastverbindung des Rastkopfes des Befestigungsteiles in der Aufnahmenut zu erhalten, sieht eine Ausgestaltung vor, daß der Rastfinger mit seiner dem Haltesteg der inneren Seitenwand zugekehrten Seite um einen Betrag gegenüber dem Rastabsatz versetzt ist, der durch den Abstand der dem Nutgrund zugekehrten Innenseite der Haltestege der Nutwände entspricht, sowie daß der Rastfinger und der Rastabsatz über gegeneinander geneigte Abschnitte in die Stützkante des Rastkopfes übergeht und daß der Abstand der Stützkante vom Rastabsatz dem Abstand des Nutgrundes von der Innenseite des Haltesteges der äußeren Nutwand entspricht. Die Schräge am Rastabsatz erleichtert das Einrasten des Haltesteges der äußeren Nutwand.

Damit der Rastfinger beim Einführen des Befestigungsteiles in die Aufnahmenut durch den Nutgrund nicht daran gehindert wird, auch den Raststeg an der inneren Nutwand zu hintergreifen, sieht eine Ausgestaltung vor, daß der Nutgrund in dem der inneren Nutwand zugekehrten Bereich gegenüber dem Haltesteg der inneren Nutwand zurückgesetzt ist.

Ist darüber hinaus vorgesehen, daß die Breite des Rastkopfes im Bereich der Spitze des Rastfingers und dem gegenüberliegenden Rastabsatz dem lichten Abstand der Nutwände entspricht, dann ist das Befestigungsteil in der eingerasteten Stellung großflächig in der Aufnahmenut verstellbar geführt.

Um Toleranzen auszugleichen, ist die Schraubverbindung zwischen der Platte und dem Befestigungsteil nach einer Ausgestaltung so ausgeführt, daß das Befestigungsteil in dem aus der Aufnahmenut ragenden Ende eine senkrecht zur Platte gerichtete, im Querschnitt als Langloch ausgebildete Durchgangsbohrung mit Innennut in den Längswänden aufweist, daß in die Innennut Haltestege eines Käfigs eingerastet sind, der eine Käfigmutter mit Gewindebohrung an dem Befestigungsteil so festhält, daß über die Durchgangsbohrung des Befestigungsteils die Gewindebohrung der Käfigmutter zugänglich ist und daß die Längswände der Durchgangsbohrung senkrecht zum Rahmenschenkel gerichtet sind. Der Käfig und die Käfigmutter sind dabei auf der der Platte abgekehrten Seite des Befestigungsteils angeordnet.

Einen mit den Rahmenschenkeln bündigen Einbau der Platte in die Gehäuseöffnung wird dadurch erreicht, daß der Rahmenschenkel mit einem an der äußeren Nutwand angeformten Abschlußsteg eine Aufnahme für die Platte bildet, der bündig mit der Außenseite der in die Aufnahme eingesetzten Platte abschließt.

Eine weitere vorteilhafte Ausgestaltung des Gegenstandes nach Anspruch 1 ergibt sich aus den Merkmalen des Anspruches 3.

Die Erfindung wird anhand eines in den Zeichnungen dargestellten Ausführungsbeispiels näher erläutert. Es zeigt:
- Fig. 1: eine Ansicht in Längsrichtung eines Rahmenschenkels mit einem schräg eingeführten Befestigungsteil,
- Fig. 2: eine der Fig. 1 entsprechende Ansicht, bei der das Befestigungsteil nach oben verschwenkt wird,
- Fig. 3: eine der Fig. 1 entsprechende Ansicht, bei der das Befestigungsteil die eingerastete Stellung einnimmt,
- Fig. 4: eine Befestigungsstelle der an dem eingerasteten Befestigungsteil angeschraubten Platte und
- Fig. 5: einen Schnitt durch die Befestigungsstelle entlang der Linie V-V der Fig. 4.

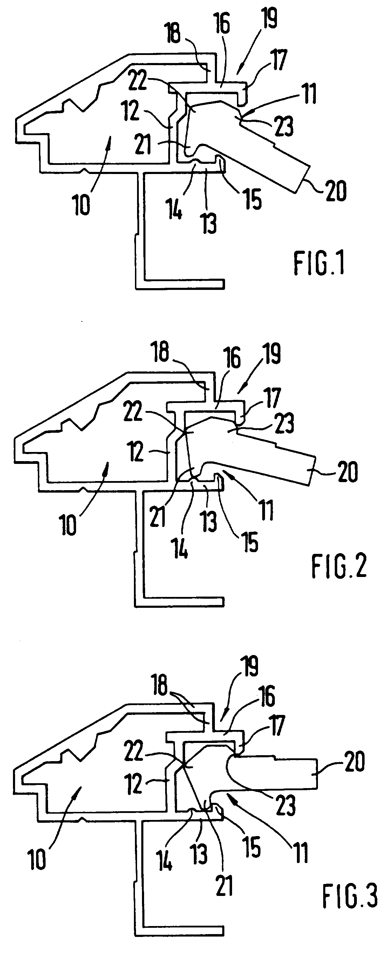

Die Fig. 1 bis 3 zeigen den Querschnitt eines als Hohlprofilabschnitt ausgebildeten Rahmenschenkels 10, der eine Seite einer Gehäuseöffnung abschließt. An der Gehäuseöffnung sind an mindestens zwei einander gegenüberliegenden Seiten derartige Rahmenschenkel 10 angeordnet. Die einander zugekehrten Seiten der beiden Rahmenschenkel 10 sind als Aufnahmenut 11 mit Nutgrund 12, einer inneren Nutwand 13 und einer äußeren Nutwand 16 ausgebildet. Dabei ist die innere Nutwand 13 kürzer als die äußere Nutwand 16. Beide Nutwände 13 und 16 sind aber an ihren freien Enden mit rechtwinklig in die Aufnahmenut 11 ragenden Haltestegen 15 und 17 versehen, die eine Einführungsöffnung in die Aufnahmenut 11 freilassen. Auf der Innenseite der inneren Nutwand 13 ist ein durchgehender Raststeg 14 angeformt, der im Abstand zum Nutgrund 12 und zum Haltesteg 15 angeordnet ist.

In die Aufnahmenut 11 werden mit einem Rastkopf 26 versehene, etwa quaderförmige Befestigungsteile 20 eingeführt, wobei wie Fig. 1 zeigt, das Befestigungsteil 20 etwa senkrecht zu der Einführungsöffnung eingeführt wird, so daß der am Rastkopf 26 angeformte Rastfinger 21 hinter den Raststeg 14 gelangen kann. Die Seite des Befestigungsteiles 20 mit dem Rastfinger 21 ist der inneren Nutwand 13 zugekehrt. Auf der gegenüberliegenden, der äußeren Nutwand 16 zugekehrten Seite bildet der Rastkopf 26 einen Rastabsatz 23, der mit einer Schräge versehen ist.

Wie Fig. 2 zeigt, wird bei Verschwenken des Befestigungsteiles 20 in Richtung zur äußeren Nutwand 16 der Rastfinger 21 über den Raststeg 14 geführt und rastet in eine Art Rastaufnahme ein, welche durch den Raststeg 14 und den Haltesteg 15 begrenzt wird, wie Fig. 3 zeigt. Hat das Befestigungsteil 20 die eingerastete Stellung erreicht, dann ist auch der Haltesteg 17 der äußeren Nutwand 16 hinter den Rastabsatz 23 des Rastkopfes 26 eingerastet, wie Fig. 3 erkennen läßt. Das Befestigungsteil 20 kann unter Beibehaltung der eingerasteten Stellung in der Aufnahmenut 11 beliebig verstellt werden. Der Rastkopf 26 läuft über geneigte Abschnitte in einer Stützkante 22 aus, die sich an dem Nutgrund 12 abstützt und beim Verschwenken des Befestigungsteils 20 den Rastvorgang zuläßt. Der der inneren Nutwand 13 zugekehrte Abschnitt des Nutgrundes 12 ist zurückgesetzt, so daß der Rastfinger 21 hinter den Raststeg 14 eingeführt werden kann, wie Fig. 1 zu entnehmen ist. Der Abstand der dem Haltesteg 15 zugekehrten Seite des Rastfingers 21 von dem Rastabsatz 23 entspricht dem Abstand der Innenseiten der Haltestege 15 und 17 und im Bereich der Spitze des Rastfingers 21 ist die Breite des Rastkopfes 26 gleich dem lichten Abstand der Nutwände 13 und 16. Das eingerastete Befestigungsteil 20 ist dann großflächig in der Aufnahmenut 11 geführt.

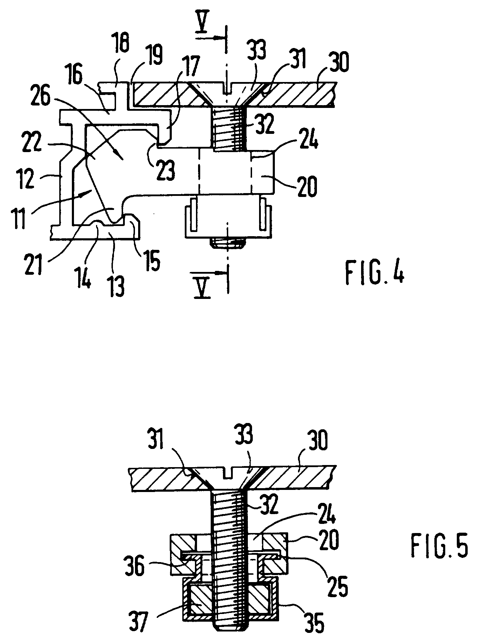

An der Außenseite der äußeren Nutwand 16 bilden Abschlußstege 18 eine Aufnahme 19, in die die Platte 30 bündig eingesetzt werden kann, wie die Fig. 4 zeigt. Das aus der Aufnahmenut 11 ragende Ende des Befestigungsteils 20 hat eine als Langloch ausgebildete Durchgangsbohrung 24 mit einer Innennut 25, die senkrecht zur Platte 30 gerichtet ist. In die senkrecht zum Rahmenschenkel 10 verlaufenden Längswände der Innennut 25 der Durchgangsbohrung 24 sind Haltestege 36 eines Käfigs 35 eingerastet, wie der Schnitt nach Fig. 5 zeigt. Der Käfig 35 hält eine Käfigmutter 37 sofest, daß über die Durchgangsbohrung 24 die Gewindebohrung der Käfigmutter 37 zugänglich ist. Der Käfig 35 und die Käfigmutter 37 sind auf der der Platte 30 abgekehrten Seite des Befestigungsteiles 20 angeordnet. Das Befestigungsteil 20 ist in der Aufnahmenut 11 so ausgerichtet, daß die in eine Senklochbohrung 31 der Platte 30 eingeführte Senkkopfschraube 32 in die Käfigmutter 37 eingeschraubt werden kann. Der Kopf 33 der Senkkopfschraube 32 stützt sich in der Senklochbohrung 31 der Platte 30 ab. Die Senkkopfschraube 32 zieht über die Käfigmutter 37 das Befestigungsteil 20 in Richtung zur Platte 30. Dabei wird der Rastfinger 21 gegen den Haltesteg 15 gedrückt und die Stützkante 22 des Rastkopfes 26 stützt sich an dem Nutgrund 12 ab. Der Haltesteg 17 wird im Eingriff mit dem Rastabsatz 23 gehalten.

Die Platte 30 wird an mindestens zwei einander gegenüberliegenden Seiten mit mindestens einer derartigen Befestigungsstelle in der Aufnahme 19 gegen die Außenseite der äußeren Nutwand 16 verspannt. Dabei schließt die Außenseite der Platte 30 bündig mit dem Abschlußsteg 18 des Rahmenschenkels 10 ab.

Das Befestigungsteil 20 kann auch selbst eine Gewindebohrung zum Einschrauben der Senkkopfschraube 32 tragen.

## Patentansprüche

1. Vorrichtung an einer Gehäuseöffnung, die an mindestens zwei einander gegenüberliegenden Seiten mit Rahmenschenkeln (10) abgeschlossen ist, bei der die Rahmenschenkel (10) auf den einander zugekehrten Seiten mit einer Aufnahmenut (11) versehen sind, die aus einem Nutgrund (12) und zwei Nutwänden (13, 16) gebildet ist, bei der die Nutwände (13, 16) mit zur Aufnahmenut hin senkrecht stehenden Haltestegen (15, 17) vorstehen, bei der in die Aufnahmenuten der Rahmenschenkel in Schrägstellung Befestigungsteile einführbar sind, bei der die auf der Außenseiten der Gehäuseöffnung liegende äußere Nutwand (16) länger ist als die auf der Innenseite der Gehäuseöffnung liegende innere Nutwand (13), bei der die Befestigungsteile (20) mit einem Rastkopf (26) versehen sind, und bei der der Rastkopf (26) der inneren Nutwand (13) Rastfinger (21) und der äußeren Nutwand (16) zugekehrt einen Rastabsatz (23) aufweist,
dadurch gekennzeichnet,
daß die Außenseite der Nutwand (16) als Auflage für eine Platte (30) dient, daß sich der Rastkopf (26) des in die Aufnahmenut (11) eingeführten Befestigungsteils (20) mit einer Stützkante (22) an dem Nutgrund (12) abstützt,
daß beim Verschwenken des Befestigungsteils (10) in Richtung zur Platte (30) der Rastfinger (21) zwischen einen Raststeg (14) und den Haltesteg (15) der inneren Nutwand (13) eingerastet ist und der Rastabsatz (23) sich an den Haltesteg (17) der äußeren Nutwand (16) anlegt und
daß die Platte (30) an jedem Rahmenschenkel (10) mittels Schraubverbindungen mit mindestens einem in die Aufnahmenut (11) eingerasteten Befestigungsteil (20) verbunden ist.

2. Vorrichtung nach Anspruch 1,
dadurch gekennzeichnet,
daß die Platte (30) zumindest einen Teil der Breite oder Höhe der Gehäuseöffnung abdeckt.

3. Vorrichtung nach Anspruch 1 oder 2,
dadurch gekennzeichnet,
daß der Rastkopf (26) über eine Schräge in den Rastabsatz (23) übergeht.

4. Vorrichtung nach einem der Ansprüche 1 bis 3,
dadurch gekennzeichnet,
daß der Rastfinger (21) mit seiner dem Haltesteg (15) der inneren Nutwand (13) zugekehrten Seite um einen Betrag gegenüber dem Rastabsatz (23) versetzt ist, der durch den Abstand der dem Nutgrund (12) zugekehrten Innenseite der Haltestege (15,17) der Nutwände (13,16) entspricht.

5. Vorrichtung nach einem der Ansprüche 1 bis 4,
dadurch gekennzeichnet,
daß der Rastfinger (21) und der Rastabsatz (23) über gegeneinander geneigte Abschnitte in die Stützkante (22) des Rastkopfes (26) übergeht und
daß der Abstand der Stützkante (22) vom Rastabsatz (23) dem Abstand des Nutgrundes (12) von der Innenseite des Haltesteges (17) der äußeren Nutwand (16) entspricht.

6. Vorrichtung nach einem der Ansprüche 1 bis 5,
dadurch gekennzeichnet,
daß der Nutgrund (12) in dem der inneren Nutwand (13) zugekehrten Bereich gegenüber dem Haltesteg (15) der inneren Nutwand (13) zurückgesetzt ist.

7. Vorrichtung nach einem der Ansprüche 1 bis 6,
dadurch gekennzeichnet,
daß die Breite des Rastkopfes (26) im Bereich der Spitze des Rastfingers (21) und dem gegenüberliegenden Rastabsatz (23) dem lichten Abstand der Nutwände (13,16) entspricht.

8. Vorrichtung nach einem der Ansprüche 1 bis 7,
dadurch gekennzeichnet,
daß das Befestigungsteil (20) in dem aus der Aufnahmenut (11) ragenden Ende eine senkrecht zur Platte (30) gerichtete, im Querschnitt als Langloch ausgebildete Durchgangsbohrung (24) mit Innennut (25) in den Längswänden aufweist,
daß in die Innennut (25) Haltestege (36) eines Käfigs (35) eingerastet sind, der eine Käfigmutter (37) mit Gewindebohrung an dem Befestigungsteil (20) so festhält, daß über die Durchgangsbohrung (24) des Befestigungsteils (20) die Gewindebohrung der Käfigmutter (37) zugänglich ist, und
daß die Längswände der Durchgangsbohrung (24) senkrecht zum Rahmenschenkel (10) gerichtet sind.

9. Vorrichtung nach Anspruch 8,
dadurch gekennzeichnet,
daß der Käfig (35) und die Käfigmutter (37) auf der der Platte (30) abgekehrten Seite des Befestigungsteils (20) angeordnet sind.

10. Vorrichtung nach einem der Ansprüche 1 bis 9,
dadurch gekennzeichnet,
daß der Rahmenschenkel (10) mit einem an der äußeren Nutwand (16) angeformten Abschlußsteg (18) eine Aufnahme (19) für die Platte (30) bildet, der bündig mit der Außenseite der in die Aufnahme (19) eingesetzten Platte (30) abschließt.

## Claims

1. Arrangement on a housing opening, which is terminated by frame members (10) on at least two oppositely situated sides, wherein the frame members (10) are provided with a receiving groove (11) on the sides facing each other, which groove is formed from a groove base (12) and two groove walls (13, 16), wherein the groove walls (13, 16) protrude with retaining webs (15, 17), which extend perpendicularly relative to the receiving groove, wherein fastening parts are insertable, in their inclined position, into the receiving grooves in the frame members, wherein the outer groove wall (16), which lies on the outside of the housing opening, is longer than the inner groove wall (13), which lies on the inside of the housing opening, wherein the fastening parts (20) are provided with a locking head (26), and wherein the locking head (26) facing the inner groove wall (13) has locking fingers (21) and, facing the outer groove wall (16), a locking shoulder portion (23), characterised in that the outside of the groove wall (16) serves as a support for a plate (30), in that the locking head (26) of the fastening part (20), which is inserted into the receiving groove (11), is supported by a supporting edge (22) on the groove base (12), in that, during the pivotal movement of the fastening part (10) in the direction towards the plate (30), the locking finger (21) is locked in position between a locking web (14) and the retaining web (15) of the inner groove wall (13), and the locking shoulder portion (23) abuts against the retaining web (17) of the outer groove wall (16), and in that the plate (30) is connected at each frame member (10) to at least one fastening part (20), which is locked in position in the receiving groove (11), by means of screw connections.

2. Arrangement according to claim 1, characterised in that the plate (30) covers at least some of the width or height of the housing opening.

3. Arrangement according to claim 1 or 2, characterised in that the locking head (26) extends over an inclination into the locking shoulder portion (23).

4. Arrangement according to one of claims 1 to 3, characterised in that the side of the locking finger (21) facing the retaining web (15) of the inner groove wall (13) is offset relative to the locking shoulder portion (23) by an amount which corresponds to the spacing between the insides of the retaining webs (15, 17) of the groove walls (13, 16) facing the groove base (12).

5. Arrangement according to one of claims 1 to 4, characterised in that the locking finger (21) and the locking shoulder portion (23) extend, via portions which are inclined towards one another, into the supporting edge (22) of the locking head (26), and in that the spacing between the supporting edge (22) and the locking shoulder portion (23) corresponds to the spacing between the groove base (12) and the inside of the retaining web (17) of the outer groove wall (16).

6. Arrangement according to one of claims 1 to 5, characterised in that the groove base (12) in the region facing the inner groove wall (13) is offset relative to the retaining web (15) of the inner groove wall (13).

7. Arrangement according to one of claims 1 to 6, characterised in that the width of the locking head (26) in the region of the tip of the locking finger (21) and in the region of the oppositely situated locking shoulder portion (23) corresponds to the unobstructed spacing between the groove walls (13, 16).

8. Arrangement according to one of claims 1 to 7, characterised in that, in the end protruding from the receiving groove (11), the fastening part (20) includes a through-bore (24), which is orientated perpendicularly relative to the plate (30) and has a cross-section configured as an elongate slot, an internal groove (25) being provided in the longitudinal walls of said bore, in that retaining webs (36) of a cage (35) are locked in position in the internal groove (25), said cage securely retaining a cage nut (37) on the fastening part (20) by a threaded bore in such a manner that the threaded bore in the cage nut (37) is accessible via the through-bore (24) in the fastening part (20), and in that the longitudinal walls of the through-bore (24) are orientated perpendicularly relative to the frame member (10).

9. Arrangement according to claim 8, characterised in that the cage (35) and the cage nut (37) are disposed on the side of the fastening part (20) remote from the plate (30).

10. Arrangement according to one of claims 1 to 9, characterised in that the frame member (10) forms with an end web (18), which is provided on the outer groove wall (16), a receiving means (19) for receiving the plate (30), which web terminates flush with the outside of the plate (30) inserted into the receiving means (19).

## Revendications

1. Dispositif sur une ouverture de carter qui le long d'au moins deux côtés est clôturée par des ailes d'encadrement (10), dans lequel les ailes d'encadrement (10) présentent une rainure de réception (11) dans les côtés qui se font face, rainure de réception (11) qui est constituée d'un fond de rainure (12) et de deux parois de rainure (13, 16), dans lequel les parois de rainure (13, 16) font par des nervures de support (15, 17) disposées perpendiculairement à la rainure de réception, des éléments de fixation pouvant être introduits en position oblique dans les rainures de fixation des ailes d'encadrement, la paroi de rainure (16) extérieure située sur le côté extérieur de l'ouverture de carter étant plus longue que la paroi de rainure intérieure (13) située sur le côté intérieur de l'ouverture de carter,les éléments de fixation présentant une tête d'encliquetage (26), la tête d'encliquetage (26) présentant un doigt d'encliquetage (21) orienté vers la paroi intérieure (13) de la rainure et un épaulement d'encliquetage (23) orienté vers la paroi extérieure (16) de la rainure,
caractérisé
en ce que la tête d'encliquetage (26) de l'élément de fixation (20) introduit dans la rainure de réception (11) d'appuie par une arête d'appui (22) sur le fond (12) de la rainure,
en ce que lors du pivotement de l'élément de fixation (10) en direction de la plaque (30), le doigt d'encliquetage (21) est encliqueté entre une nervure d'encliquetage (14) et la nervure de support (15) de la paroi intérieure (13) de la nervure et tandis que l'épaulement d'encliquetage (23) s'applique contre la nervure de support (17) de la paroi extérieure (16) de la rainure, et
en ce que la plaque (30) est au moyen d'assemblages à vis reliée à au moins un élément de fixation (20) encliqueté dans la rainure de réception (11).

2. Dispositif suivant la revendication 1, caractérisé en ce que la plaque (30) recouvre au moins une partie de la largeur ou de la hauteur de l'ouverture de carter.

3. Dispositif suivant la revendication 1 ou la revendication 2,
caractérisé
en ce que la tête d'encliquetage (26) se raccorde par un biseau à l'épaulement d'encliquetage(23).

4. Dispositif suivant l'une quelconque des revendications de 1 à 3,
caractérisé
en ce que le doigt d'encliquetage (21) est par son côté orienté vers la nervure de support (15) de la paroi intérieure (13) de la rainure décalé par rapport à l'épaulement d'encliquetage (23) d'une longueur qui correspond à la distance entre le côté intérieur des nervures de support (15, 17) des parois (13, 16) de la rainure et le fond (12) de la rainure.

5. Dispositif suivant l'une quelconque des revendications de 1 à 4,
caractérisé
en ce que le doigt d'encliquetage (21) et l'épaulement d'encliquetage (23) sont par des tronçons inclinés l'un par rapport à l'autre raccordés à l'arête d'appui (22) de la tête d'encliquetage (26), et
en ce que la distance entre l'arête d'appui (22) et l'épaulement d'encliquetage (23) correspond à la distance entre le fond (12) de la rainure et le côté intérieur de la nervure de support (17) de la paroi extérieur (16) de la rainure.

6. Dispositif suivant l'une quelconque des revendications de 1 à 5,
caractérisé
en ce que dans la région orientée vers la paroi intérieure (13) de la rainure, le fond (12) de la rainure est en retrait par rapport à la nervure de support (15) de la paroi intérieure (13) de la rainure.

7. Dispositif suivant l'une quelconque des revendications de 1 à 6,
caractérisé
en ce que dans la région du sommet du doigt d'encliquetage (21) et de l'épaulement d'encliquetage (23) situé en face, la largeur de la tête d'encliquetage (26) correspond à la distance intérieure des parois (13, 15) de la rainure.

8. Dispositif suivant l'une quelconque des revendications de 1 à 7,
caractérisé
en ce que dans l'extrémité qui émerge de la rainure de réception (11), l'élément de fixation (20) présente une forure de passage (24) orientée perpendiculairement à la plaque (30), à section transversale en forme de trou oblong et présentant une rainure intérieure (25) dans ses parois longitudinales,
en ce que dans la rainure intérieure ((25) sont encliquetées des nervures de support (36) d'une cage (35), laquelle maintient sur l'élément de fixation (20) un écrou de cage (37) à forure filetée de manière telle que la forure filetée de l'écrou de cage (37) est accessible au travers la forure de passage (24) de l'élément de fixation (20), et
en ce que les parois longitudinales de la forure de passage (24) sont orientées perpendiculairement à l'aile d'encadrement (10).

9. Dispositif suivant la revendication 8,
caractérisé
en ce que la cage (35) et l'écrou de cage (37) sont disposés du côté de l'élément de fixation (20) qui n'est pas orienté vers la plaque (30).

10. Dispositif suivant l'une quelconque des revendications de 1 à 9,
caractérisé
en ce que par sa nervure de clôture (18) formée sur la paroi extérieure (16) de la rainure, l'aile d'encadrement (10) constitue un logement de réception (19) pour la plaque (30), la nervure de clôture (18) étant à fleur avec le côté extérieur de la plaque (30) mise en place dans le logement de réception (19).
